# EUROPEAN PATENT APPLICATION

(11) **EP 2 650 901 A1**
(43) Date of publication of application: **16.10.2013**
(21) Application number: 11847394.1
(22) Date of filing: 30.11.2011
(51) Int. Cl.: H01J 37/147, H01J 37/317

(54) **CHARGED PARTICLE BEAM APPARATUS AND METHOD OF IRRADIATING CHARGED PARTICLE BEAM**

(30) Priority: 06.12.2010 JP 2010271806
(71) Applicant: Hitachi High-Technologies Corporation, Tokyo 105-8717 (JP)
(72) Inventor: NOMAGUCHI, Tsunenori, Ibaraki 312-8504 (JP); SEKIHARA, Isamu, Ibaraki 312-8504 (JP); AGEMURA, Toshihide, Ibaraki 312-8504 (JP)
(74) Representative: Beetz & Partner
(86) International application number: PCT/JP2011/077670
(87) International publication number: WO 2012/077554

(57) **Abstract**

In order to provide a charged particle beam apparatus capable of irradiating a desired region in the surface of a sample with a charged particle beam from a wide range of angles, an electrode unit (204) comprising an electrode, the inclination angle of which (i.e. the angle of inclination relative to a plane orthogonal to the extension line of the center axis of the ion beam column (201a)) and the position of which (i.e. the position in the direction along the extension line of the center axis of the ion beam column (201a) and in directions orthogonal thereto) can be adjusted, is arranged within a sample chamber (203) of the charged particle beam apparatus. The charged particle beam apparatus is also configured so that a curved ion beam (201b) is irradiated onto a surface of a sample (202) by the electrode. This enables irradiation of the ion beam (201b) to a desired range within the surface of the sample (202), from a wide range of angles with respect to the sample surface.

## Description

### Technical Field

The present invention relates to, for example, a charged particle beam apparatus and a method of irradiating charged particle beam.

### Background Art

In recent years, focused ion beam (FIB) apparatuses are used for producing thin film samples for observation of (scanning) transmission electron microscope ((S)TEM). Specifically, in producing thin film samples for analyzing defects of semiconductor devices, FIB apparatus is a necessary tool.

In recent years, structural objects are being miniaturized in various industries such as the energy industry like fuel cell or solar cell and the industries using organic materials like organic electro-luminescence (EL) displays, with the semiconductor industry at the top of list. Improving processing techniques for observation samples and analysis samples is thus needed. For example, devices with node size of 30 nm or less are being applied in state of the art devices. In producing thin film samples of such devices for (S)TEM, nanometer-order processing accuracy is required. In addition, as structural objects become miniaturized and complicated, roughness of process cross-section (curtaining pattern) due to mixed light elements and heavy elements becomes a larger issue for (S)TEM observation samples. Therefore, in finally finishing (S)TEM observation thin film samples, it is required to accurately remove damaged layers and curtaining patterns in desired regions.

In order to solve the problem above, Patent Literature 1 indicates a method of using, for removing damaged layers, a second ion beam (argon ion) that is different from a first ion beam (gallium ion) used for thin film processing.

In addition, Patent Literature 2 indicates a method for removing damaged layers by irradiating an argon ion onto a film sample piece using an ion milling apparatus.

In addition, Patent Literature 3 describes a method for decreasing damaged layers wherein energy of an ion beam used for finish processing is made lower than energy of an ion beam used for main processing. Further, it is also indicated that decrease in throughput can be suppressed by finish-processing the sample being inclined with respect to the ion beams.

In addition, as a problem other than damaged layers, vertical cross-sections cannot be obtained by irradiating focused ion beams vertically with respect to the surface of samples. This is because the shape of focused ion beams is focused at the focused location. Thus a thin film sample is not appropriate as that for (S)TEM observation if it doesn't have a cross section that is vertical with respect to the surface of sample.

As a method for preventing this problem, Patent Literature 4 indicates a method for obtaining a vertical cross section by irradiating an ion beam with a sample being inclined by a predetermined angle. The processing is generally performed with the surface of sample being inclined by 3 to 5 degree with respect to the center axis of ion beam.

In addition, Patent Literature 5 describes a technique that can change the angle of ion beam with respect to the surface of sample from 75 degree to 90 degree using an angle changing electrode.

### Citation List

### Patent Literature

Patent Literature 1: JP Patent Publication (Kokai) No. 2004-264145 A
Patent Literature 2: JP Patent Publication (Kokai) No. 2002-277364 A
Patent Literature 3: JP Patent Publication (Kokai) No. 2007-193977 A
Patent Literature 4: JP Patent Publication (Kokai) No. H08-5528 A (1996)
Patent Literature 5: JP Patent Publication (Kokai) No. 2002-148159 A

### Summary of Invention

### Technical Problem

However, in techniques described in Patent Literatures 1 to 3, there is a significant restriction in irradiation direction of ion beam. Therefore, it is difficult to irradiate ion beams onto desired regions of sample only and to irradiate ion beams with optimal angle.

As the technique described in Patent Literature 4, in a technique where samples are inclined with respect to ion beams, it is also difficult to irradiate ion beams with desired angles onto desired regions by sample inclination only.

Furthermore, in the technique described in Patent Literature 5, the angle of ion beams with respect to sample surfaces can be changed. However, it is impossible to irradiate ion beams with angles more than it. Thus it is difficult to irradiate ion beams with desired angles onto desired regions.

The objective of the present invention is to achieve a charged particle beam apparatus and a method of irradiating charged particle beam that can irradiate charged particle beams onto desired regions of sample surfaces with wide range of angles.

### Solution to Problem

A charged particle beam apparatus according to the present invention comprises: an ion beam column; a sample chamber with the ion beam column attached to it; a sample stage located in the sample chamber; an electrode unit that is located in the sample chamber and changes a trajectory of an ion beam so that the ion beam is irradiated onto a sample supported by the sample stage; and an electrode unit movement control unit that moves the electrode unit.

The electrode unit can change a trajectory of the ion beam generated from the ion beam column by changing an angle between the ion beam and an extended line of a center axis of the ion beam column. Thus the ion beam can be irradiated onto samples supported by the sample stage.

### Advantageous Effects of Invention

According to the present invention, it is possible to achieve a charged particle beam apparatus and a method of irradiating charged particle beam that can irradiate charged particle beams onto desired regions of sample surfaces with wide range of angles.

### Brief Description of Drawings

[Figure 1] Figure 1 is a schematic configuration diagram of a charged particle beam apparatus according to an example 1 of the present invention.
[Figure 2] Figure 2 is a diagram showing an example of an ion beam trajectory in the example 1 of the present invention.
[Figure 3] Figure 3 is a diagram showing another example of an ion beam trajectory in the example 1 of the present invention.
[Figure 4] Figure 4 is a diagram explaining another example of an ion beam trajectory in the example 1 of the present invention.
[Figure 5] Figure 5 is a diagram showing another example of an ion beam trajectory in the example 1 of the present invention.
[Figure 6] Figure 6 is a comparative explanation diagram between the method for removing damaged layer according to the example 1 of the present invention and another example of the present invention.
[Figure 7] Figure 7 is a schematic configuration diagram of a charged particle beam apparatus according to an example 2 of the present invention.
[Figure 8] Figure 8 is a diagram showing an example of an ion beam trajectory in the example 2 of the present invention.

### Description of Embodiments

In the present invention, an electrode unit for bending a trajectory of a charged particle is provided in a sample chamber of a charged particle beam apparatus comprising an ion beam column. The charged particle beams are bended by an electric field generated by the electrode unit to be irradiated onto a sample.

Hereinafter, embodiments of the present invention will be described with reference to attached drawings. However, the embodiments described below are merely examples for implementing the present invention, and it is not intended to limit the technical scope of the present invention.

### Examples

### (Example 1)

### (Explanation for configuration of charged particle beam apparatus)

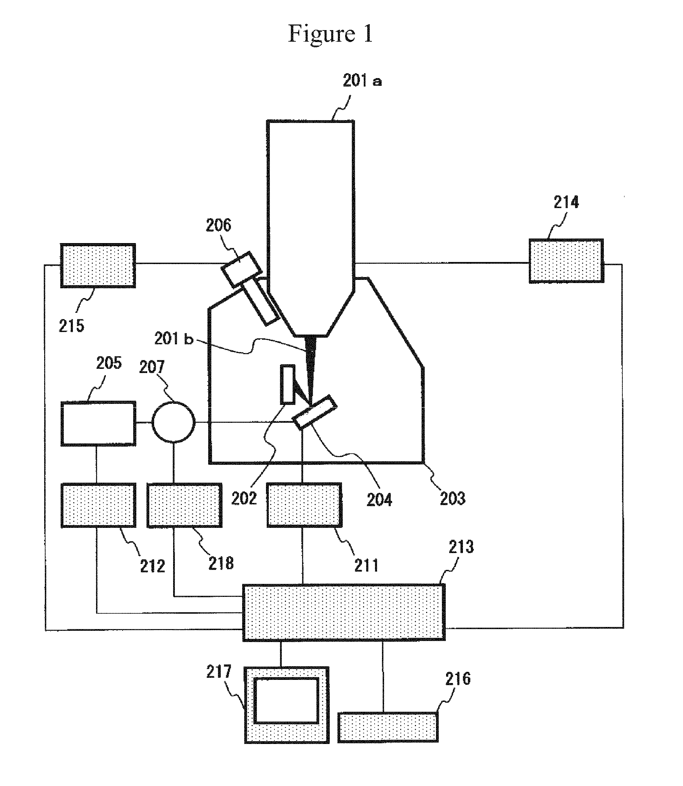

Figure 1 is a schematic overall configuration diagram of a charged particle beam apparatus according to an example 1 of the present invention.

In Figure 1, the charged particle beam apparatus comprises: an ion beam column 201a; a sample chamber 203; an electrode unit 204 that is provided in the sample chamber 203, is capable of being applied of electric voltages, is movable in any direction, and is capable of adjusting its inclination angle; an electrode controller 211 that controls a location and an angle of the electrode unit 204; an electric voltage supplying device 205 for applying an electric voltage to the electrode unit 204; an electric voltage controller 212 that controls the electric voltage supplying device 205; and an integration computer 213 that controls overall operations of the charged particle beam apparatus.

The charged particle beam apparatus further comprises: an ion beam scan controller 214 for controlling a scan of an ion beam 201b generated from the ion beam column 201a; a detector 206 for obtaining a scanning ion microscope (SIM) image; a detector controller 215 that provides the integration computer 213 with the detected information; a controller (such as a keyboard, a mouse) 216 for operators to input various instructions such as irradiation conditions or electric voltage conditions and location conditions of electrodes; and a display 217 that displays the obtained SIM images.

The charged particle beam apparatus further comprises: an ammeter 207 for using the electrode unit 204 as a second detector; and an ammeter controller 218 that performs processing such as amplifying electric current values detected by the ammeter 207. An electric current measuring signal from the ammeter controller 218 is provided to the integration computer 213.

The ion beam column 201a is a system that includes all configurations necessary for FIB, such as an ion source for generating the ion beam 201b, a lens for focusing the ion beam 201b, a deflection system for scanning and shifting ion beams. The ion beam column 201a is equipped in the sample chamber 203. Gallium ion is typically used for the ion beam 201b. However, any ion species can be used for the purpose of processing.

The ion beam 201b is not limited to focused ion beams and it can be a broad ion beam. In the example 1 of the present invention, a FIB column 201 a is provided. However, two or more than two of ion beam columns can be provided. For example, a configuration with a Ga focused ion beam column and an Ar focused ion beam column may be allowed.

The electric voltage supplying device 205 supplying electric voltages to the electrode unit 204 can be modulated. Each of controllers can communicate with each other, and is controlled by the integration computer 213.

In the example 1, a detector 206 for obtaining SIM images is provided. However, a configuration with two or more than two of same or different detectors may be allowed. For example, a secondary electron detector and a secondary ion detector may be equipped.

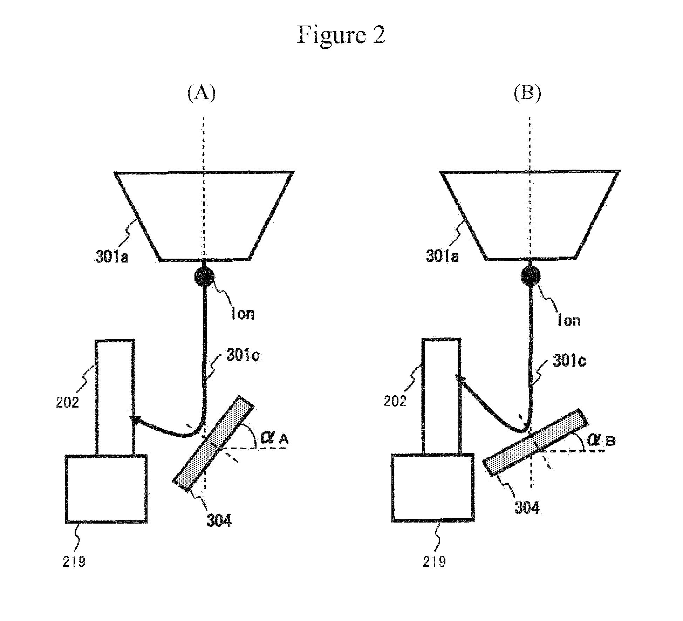

Other than above-mentioned configurations, a sample stage, a gas deposition unit, a micro sampling unit, and the like are equipped in the sample chamber 203. A sample 202 can be placed on a sample stage 219 (shown in Figure 2) for carrying samples. The sample stage 219 can perform in-plane movement, rotation, and inclination. The sample stage 219 can also move portions required for ion beam processing or observation to positions where ion beams are irradiated.

Other than semiconductor materials, iron and steel, light metal, polymer molecule, and the like can be expected as the sample 202. The gas deposition unit that is used for producing protection films or markings stores deposition gases that form deposition films by irradiating charged particle beams, and can provide the gases from a nozzle tip as required.

The micro sampling unit picks up specific portions of the sample 202 by using with processing or cutting of the sample 202 by FIB. The micro sampling unit includes a probe that can be moved in the sample chamber 203 by a probe driving unit. The probe is utilized for picking out small sample pieces formed in the sample 202 and for contacting with the sample surface to provide electric potentials to the sample.

The detector controller 215 may comprise a circuit or a processing unit that processes a detection signal from the detector 206 for imaging it. Each of driving mechanisms such as the sample stage, the deposition unit, and the micro sampling unit has control circuits respectively. Those control circuits can communicate with each other and are controlled by one or a plurality of computers in integrated manner.

Figure 2, Figure 3, and Figure 4 are magnified diagrams around the sample 202 shown in Figure 1.

Figure 2 shows a case where an electrode included in the electrode unit 204 is a planar electrode 304. It shows that an ion beam 301c from a tip 301a of the ion beam column 201a is bended and is irradiated onto the sample 202 supported by the sample stage 219. In this case, it is possible to change the irradiation position and the irradiation angle of the ion beam 301c on the sample 202 by changing the location (the location in the direction along the extended line of the center axis of the ion beam column 201a, the location in the direction perpendicular to the extended line of the center axis of the ion beam column 201a) and the inclination angle α (the inclination angle with respect to the surface perpendicular to the extended line of the center axis of the ion beam column 201a) of the planar electrode 304. Figure 2(A) shows a case where the inclination angle is α_{A} and Figure 2(B) shows a case where the inclination angle is α_{B}.

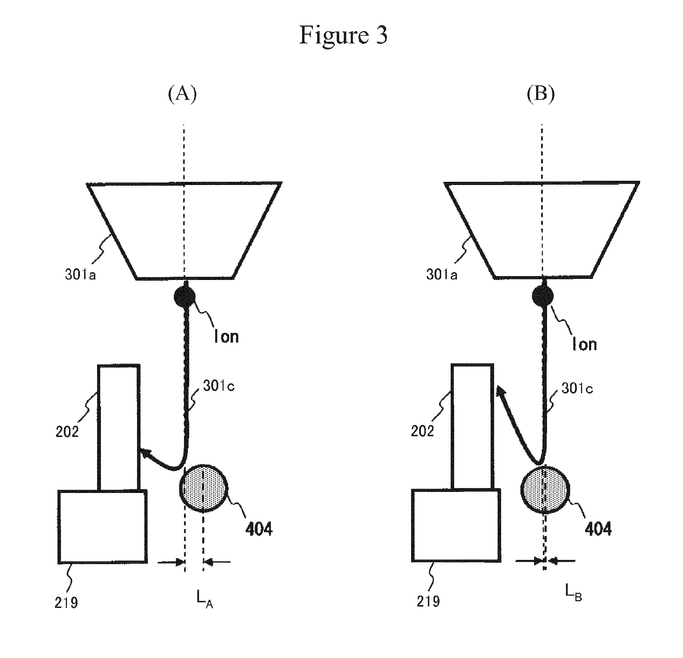

Figure 3 shows a case where an electrode included in the electrode unit 204 is a spherical electrode 404. In this case, it is possible to change the irradiation position and the irradiation angle of the ion beam on the sample 202 by horizontally moving the spherical electrode 404 (move in the direction perpendicular to the extended line of the center axis of the ion beam column 201a). Figure 3(A) is a case where the distance between the extended line of the center axis of the ion beam column 20 1 a and the center of the spherical electrode 404 is L_{A}. Figure 3(B) is a case where the distance between the extended line of the center axis of the ion beam column 201a and the center of the spherical electrode 404 is L_{B}. L_{A} is larger than L_{B}.

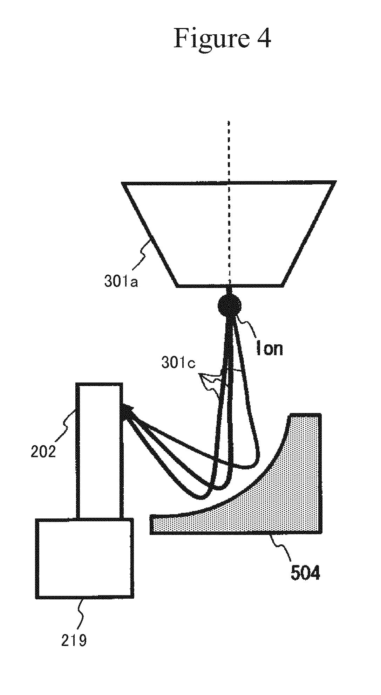

Figure 4 shows a case where an electrode included in the electrode unit 204 is a parabola-shaped (paraboloidal surface shape) electrode 504. The figure indicates that it is possible to suppress expansion of irradiation position of the ion beam 301c by using the parabola-shaped electrode 504.

If an electrode in which electrodes with shapes shown in Figures 2, 3, and 4 are combined is used, it is possible to achieve various irradiation positions and irradiation angles by changing the location, inclination angle, and rotation angle of the electrode. In addition, it is also possible to change irradiation positions and irradiation angles by modulating the voltage applied to the electrode. In other words, it is possible to irradiate ion beams onto desired locations with desired angles by combining electrode shape, electrode voltage, electrode position, irradiation direction of ion beam, and sample movement. Specifically, it is possible to irradiate ion beams onto sample surfaces with wide range of angles by changing the angle of the planar electrode 304 from being perpendicular to the extended line of the center axis of the ion beam column 201a to being horizontal.

Alternatively, it is possible to irradiate ion beams across the surface of sample 202 by changing the angle between the ion beam 301c and the extended line of the center axis of the ion beam column 201a using the electrode unit 204, and by moving the electrode unit 204 from side to side and up and down with the changed beam angle being kept.

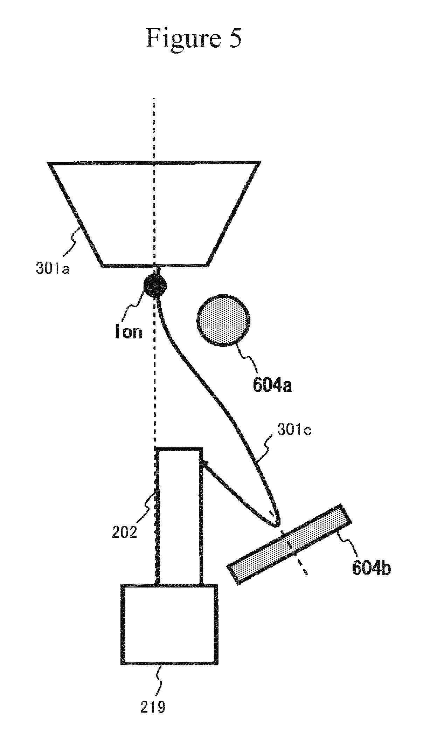

In addition, as shown in Figure 5, it is also possible to achieve desired irradiation locations and irradiation angles of the sample 202 by using a plurality of an electrode 604a (spherical electrode), an electrode 604b (planar electrode) simultaneously. For example, it is possible to place the spherical electrode 604a (a first electrode unit) near the tip 301a of the ion beam column 201a and to place the planar electrode 604b (a second electrode unit) near the sample 202.

For the purpose of bending the trajectory of the ion beam 301c, the electrode unit 204 can be supported in any manner. For example, an electrode supporting unit may be additionally provided, or the electrode can be attached instead of the micro sampling probe. Of course, the micro sampling probe itself can be an alternative of the electrode. In a case where a plurality of the sample stages 219 is provided, the electrode unit 204 can be supported on one of the sample stages 219. For example, in a charged particle beam apparatus comprising: a sample stage with a XYZ driving mechanism, an inclination mechanism, and a rotation mechanism (eucentric stage); and a (S)TEM common sample holder, the electrode unit 204 for bending trajectories of ions can be supported by the eucentric stage and the sample can be supported by the (S)TEM common sample holder. In this case, the electrode controller 211 can be configured to control the operations of the stage supporting the electrode unit 204.

In addition, other than planar electrode, spherical electrode, and parabola-shaped electrode, a polyhedral electrode can be applied as an example of above-mentioned electrodes.

### (Explanation for irradiating ion beams in any direction)

It is possible to irradiate ion beams from any direction by equipping, in a sample chamber, an electrode for bending ion trajectories in a charged particle beam apparatus having above-mentioned configurations and being capable of irradiating ion beams. Hereinafter, an explanation for such effects will be provided.

When processing a sample with heavy element and light element being mixed using ion beams, the processing result will be uneven due to the difference of sputtering rate, thus threads are formed in cross sections. For example, in a portion where heavy element and light element are present alternately in upper portions of the sample, the sputtering rate for such a portion will be decreased and threads will be formed in processing cross sections. This thread can be removed or decreased by arbitrarily changing irradiation direction of ion beams so that the sputtering rate will be even.

In addition, in producing thin film samples for (S)TEM, it is possible to prevent surface unevenness in observed regions by employing irradiation direction of ion beams such that the heavy element region is placed under the observed regions of the sample.

According to the example 1 of the present invention, it is possible to irradiate ion beams from such irradiation directions.

In addition, it is possible to remove damaged layers due to irradiation of ion beams efficiently.

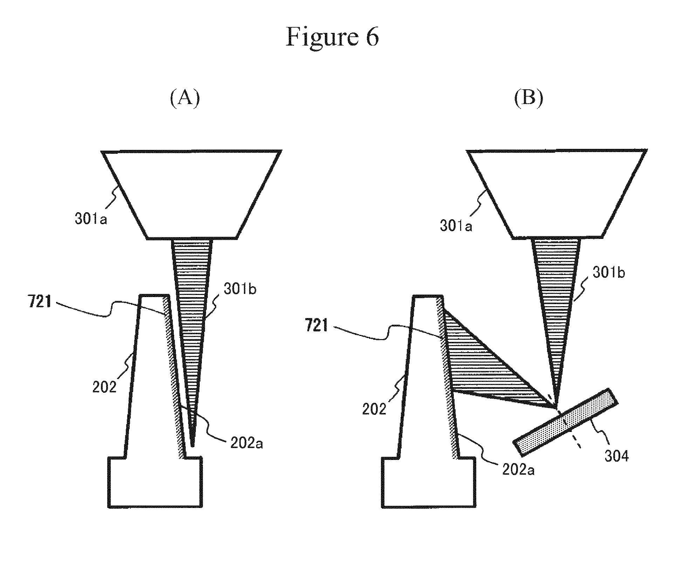

Figure 6(A) shows a method for removing damaged layers where the present invention is not employed. If the surface 202a of the sample 202 is processed using an ion beam 301b, a damaged layer 721 is formed in the sample 202. The ion beam 301b used for removing the damaged layer 721 is irradiated from the same direction as the main processing beam. Therefore, as shown in Figure 6(A), a very small portion of the ion beam 301b (a portion of side portion of the ion beam 301b) is used for removing the damaged layer 721. Thus it is very ineffective.

In contrast, in the example shown in Figure 6(B) where the present invention is applied, the surface 202a of the sample 202 is processed using the ion beam 301b with the planar electrode 304 being moved from the shown location. After that, the sample 202 is moved and the planar electrode 304 is moved to the shown location, thereby bending the ion beam 301b using the planar electrode 304 to irradiate the damaged layer 721. According to such operation, the ion beam 301b can be utilized with small loss to remove the damaged layer 721 efficiently.

In addition, it is also possible to remove surface unevenness by controlling the location and inclination of the electrode 304 to irradiate the sample 202 at desired regions with desired angles. For example, it is possible to efficiently remove surface roughness generated by irradiating ion beams. At that time, in addition to the location and inclination of the electrode 304, the location and inclination of the sample 202 may be adjusted.

In addition, in producing thin film samples for (S)TEM, as indicated in Patent Literature 4, a method for obtaining vertical processing cross sections is employed in which a sample is inclined and then ion beams are irradiated. However, if the irradiation directions of ion beams can be arbitrarily selected, it is possible to obtain vertical processing cross sections without inclining samples. Furthermore, it is possible to intensively remove thick portions of the thin film (skirt portion) efficiently by irradiating ion beams from the bottom.

Furthermore, the present invention is significantly beneficial in terms of observation in that ion beams can be irradiated from any direction. For example, it is possible to obtain SIM images from various directions even for a sample stage without inclination mechanism and rotation mechanism. For example, it is possible to obtain SIM images observed from bottom of column or SIM images observed from horizontal directions with respect to the optical axis. As a result, it is possible to more precisely analyze the three-dimensional structure of samples. Note that an electrode can be used as a detector in obtaining SIM images.

By the way, in Figure 1, if the electrode 204 in which a positive voltage is applied is placed near the sample 202, most of secondary electrons emitted from the sample 202 are attracted by the electric voltage of the electrode 204, thus cannot reach the detector 206. Therefore, it is difficult for the detector 206 to obtain SIM images.

Then, the electric current arriving at the electrode 204 is measured using the ammeter 207, and the measured electric current signal is provided to the integration computer 213 through the ammeter controller 218. The integration computer 213 obtains SIM images according to the electric current signal provided from the ammeter controller 218. Therefore, SIM images can be obtained even if the electrode 204 is placed near the sample 202.

If the electrode 204 with a negative charge applied to it is placed near the sample 202, the same thing can be said for secondary ions emitted from the sample 202.

As such, it is possible to efficiently remove amorphous layers and roughness of observed surfaces that are formed by irradiating focused ion beams and to more precisely know how the sample is being processed.

### (Low magnification observation)

Next, a description will be provided explaining that observable ranges with low magnification can be expanded according to the example 1 of the present invention.

As the example 1 of the present invention, the travel distance of ion beams can be extended by irradiating ion beams onto the sample 202 in bypassing manner. The scannable range of ion beams depends on the distance from the emitted point of the ion beam column 201a and the sample 202. As the distance becomes longer, the observed region becomes wider.

Therefore, according to the example 1 of the present invention, the scan range of focused ion beams can be expanded. In other words, observable range with low magnification can be expanded. This is beneficial in searching field of views. Further, it can be utilized when wider range is desired to be processed.

As discussed above, according to the example 1 of the present invention, the electrode 204 such as the electrode 304, 404, 504 is placed in the sample chamber 203, the electrode 204 being capable of adjusting its location in the direction along the extended line of the center axis of the ion beam column 201 a, the location in the direction perpendicular to the extended line, and the inclination angle α (the inclination angle with respect to the surface perpendicular to the extended line of the center axis of the ion beam column 201a). The ion beam 301c bended by the electrode 304 and the like is irradiated onto the surface of sample 202. Thus a charged particle beam apparatus and a method of irradiating charged particle beam that can irradiate ion beams onto desired regions of sample surface inclined by any angle of wide range with respect to the sample surface can be achieved.

As discussed above, according to the example 1 of the present invention, an apparatus that can efficiently remove damaged layers and surface roughness that are formed on the surface irradiated by ion beams in FIB processing can be provided.

Furthermore, the distance between the point where ion beams are emitted from the ion beam column 201 a and the sample surface can be extended. Therefore, the scan range can be expanded, thus the observed range with low magnification can be expanded.

### (Example 2)

### (Explanation for configuration of charged particle beam apparatus)

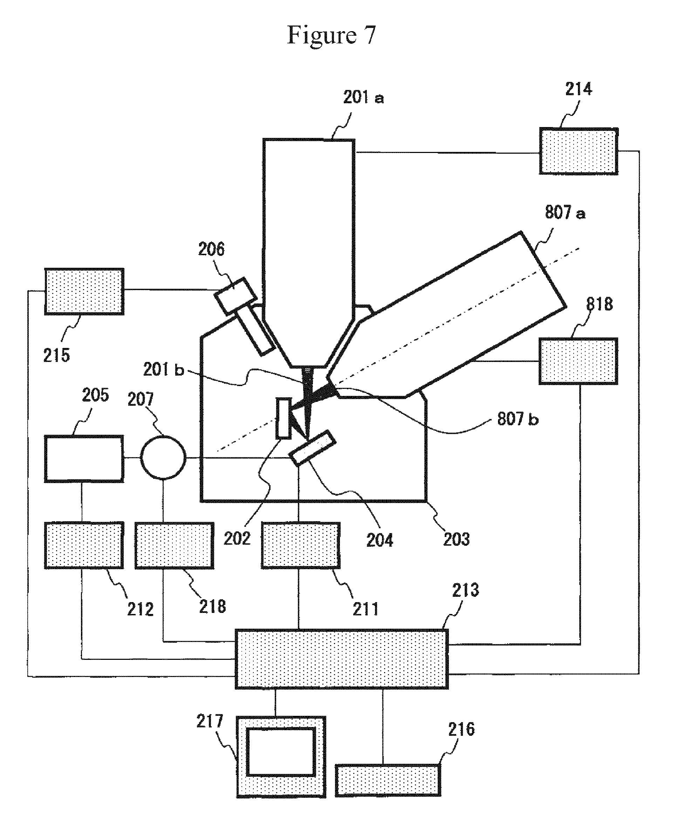

Figure 7 is a schematic overall configuration diagram of a charged particle beam apparatus according to an example 2 of the present invention.

In addition to the apparatus configuration in the example 1, the charged particle beam apparatus in the example 2 comprises: a SEM column 807a; and an electron beam scan controller 818 for controlling a scan of an electron beam 807b of the SEM column 807a. Other configurations are the same as the example 1.

The SEM column 807a is a system that includes all configurations necessary for SEM, such as an electron source for generating electron beams, a lens for focusing the electron beam, and a deflection system for scanning and shifting electron beams.

The charged particle beam apparatus according to the example 2 of the present invention is an apparatus that can SEM-observe cross sections of the sample 202 processed by FIB on site.

In the example 2 of the present invention, the ion beam column 201a is placed vertically and the SEM column 807a is placed with inclination. However, they are not limited to such configurations. The ion beam column 201a can be placed with inclination and the SEM column 807a can be placed vertically. In addition, both of the ion beam column 201a and the SEM column 807a can be placed with inclinations.

The charged particle beam device may have a triple column configuration with a Ga focused ion beam column, an Ar focused ion beam column, and an electron beam column. In addition, in the example 2 of the present invention, the detector for obtaining SEM images, the detector controller that provides the integration computer with the detected information, and the display that displays SEM images generated from the detection signals are the same as those for SIM images. However, the charged particle beam apparatus may have one or more than one of detectors, detector controllers, and displays as the mechanism for obtaining and displaying SEM images.

### (SEM observation of processing state)

A description will be provided explaining SEM-observation of processing state in the example 2 of the present invention.

In the example 2 of the present invention in which the charged particle beam apparatus comprises the SEM column 807a, the processing state of the ion beam 201b can be SEM-observed from various directions by irradiating electrons with bended trajectories onto the sample 202.

When observing the front surface of the sample 202, the processing state can be SEM-observed by irradiating the electron beam 807b from the SEM column 807a onto the front surface of the sample 202, as shown in Figure 7.

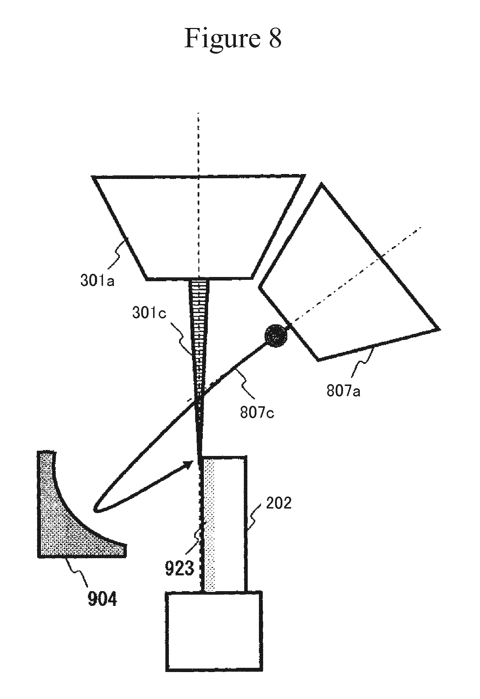

In addition, as shown in Figure 8, a parabola-shaped electrode 904 is placed so that the trajectory of the electron beam 807c from the SEM column 807a is bended to the sample 202 placed at the location where the ion beam 301c emitted from the tip 301a of the ion beam column 201a is irradiated. According to this, the back side 923 of the sample 202 viewed from the SEM column 807a can be observed. Therefore, the processing state can be identified at both sides of the thin film sample 202, thus sample processing accuracy can be improved.

When SEM-observing the sample back side 923 viewed from the SEM column 807a during processing samples by irradiating the ion beam 201b, the acceleration voltage of the ion beam 301c is preferably set higher than the acceleration voltage of the electron beam 807c. That can achieve the electron trajectory as shown in Figure 8 with very small influence on the ion beam 301c.

On the other hand, when SEM-observing during processing samples using the ion beam 201b with trajectories bended by the electrode 204, the acceleration voltage of the ion beam 807c is preferably set higher than the acceleration voltage of the electron beam 201b. That can achieve SEM observation with very small influence on the electron beam 807b.

In addition, the travel distance of the electron beam 807b can be extended by irradiating the electron beam 807b onto the sample 202 in bypassing manner. This enables to expand the observable range with low magnification in SEM observation, as in the case of SIM observation.

According to the example 2 of the present invention, the same advantageous effect as that of the example 1 can be achieved. In addition, as described above, desired locations of the sample surface during processing by ion beams can be observed by SEM.

Both in the example 1 and 2 of the present invention, electric fields are used for changing the trajectories of charged particles. However, magnetic fields also can be used for changing the trajectories of charged particles. For example, the trajectories of charged particles can be changed by placing coils or permanent magnets in the sample chamber.

In addition, thin film samples of state-of-the-art devices or functional materials can be produced with high quality, processing efficiency improves significantly, and analyzing accuracy in (S)TEM improves significantly.

Furthermore, the FIB-SEM apparatus provides an apparatus that can SEM-observe the front surface of the sample as well as the back surface. In producing thin film samples, the both sides can be observed without moving the sample, thus processing accuracy and processing reproducibility improves significantly.

### Reference Signs List

201a: ion beam column, 201b, 301b, 301c: ion beam, 202: sample, 202a: sample surface, 203: sample chamber, 204: electrode unit, 205: electric voltage supplying device, 206: detector, 207: ammeter, 211: electrode controller, 212: electric voltage controller, 213: integration computer, 214: ion beam scan controller, 215: detector controller, 216: controller, 217: display, 218: ammeter controller, 219: sample stage, 721: damaged layer, 301a: ion beam column tip, 304, 604b: planar electrode, 404, 604a: spherical electrode, 504, 904: parabola electrode, 807a: scanning electron microscope column, 807b: electron beam, 807c: electron beam, 818: electron beam scan controller, 923: sample back surface

## Claims

1. A charged particle beam apparatus comprising:
an ion beam column irradiating an ion beam;
a sample chamber with the ion beam column attached to it;
a sample stage that is located in the sample chamber and supports a sample;
an electrode unit that is located in the sample chamber and changes a trajectory of the ion beam generated from the ion beam column so that the ion beam is irradiated onto the sample supported by the sample stage;
an electrode unit movement controller moving the electrode unit in the sample chamber; and
an electric voltage supplying unit supplying an electric voltage to the electrode unit.

2. The charged particle beam apparatus according to claim 1, wherein:
the electrode unit movement controller controls a location of the electrode unit and an inclination angle of the electrode unit.

3. The charged particle beam apparatus according to claim 2, wherein:
the electrode unit is located below the sample supported by the sample stage viewed from the ion beam column so that the ion beam is irradiated onto the sample.

4. The charged particle beam apparatus according to claim 2, wherein:
the electrode unit includes a planar electrode.

5. The charged particle beam apparatus according to claim 2, wherein:
the electrode unit includes a spherical electrode.

6. The charged particle beam apparatus according to claim 2, wherein:
the electrode unit includes a paraboloid-shaped electrode.

7. The charged particle beam apparatus according to claim 2, wherein:
the electrode unit includes an polyhedral electrode.

8. The charged particle beam apparatus according to claim 1, wherein:
the electrode unit includes a first electrode unit placed near the ion beam column and a second electrode unit placed near the sample stage.

9. The charged particle beam apparatus according to claim 1, further comprising:
an electric current measuring unit detecting a secondary ion or a secondary electron arriving at the electrode unit; and
an integration computer forming a scanning ion microscope image according to the secondary ion or the secondary electron measured by the electric current measuring unit.

10. A charged particle beam apparatus comprising:
an ion beam column irradiating an ion beam;
a sample chamber with the ion beam column attached to it;
a plurality of sample stages that are located in the sample chamber and support a sample;
an electrode unit that is located in one of the plurality of sample stages located in the sample chamber and changes a trajectory of the ion beam generated from the ion beam column so that the ion beam is irradiated onto the sample supported by another one of the plurality of sample stages;
an electrode unit movement controller moving the electrode unit in the sample chamber; and
an electric voltage supplying unit supplying an electric voltage to the electrode unit.

11. The charged particle beam apparatus according to claim 10, wherein:
the electrode unit movement controller controls a location of the electrode unit and an inclination angle of the electrode unit.

12. The charged particle beam apparatus according to claim 10, wherein:
the electrode unit movement controller locates the electrode unit below the sample supported by the sample stage viewed from the ion beam column so that the ion beam is irradiated onto the sample.

13. The charged particle beam apparatus according to claim 1, further comprising:
a scanning electron microscope column irradiating an electron beam onto the sample supported by the sample stage or onto the electrode unit; and
an electron beam scan controller controlling a scan of the electron beam irradiated from the scanning electron microscope column.

14. A method of irradiating charged particle beam in a charged particle beam apparatus comprising an ion beam column irradiating an ion beam, a sample chamber with the ion beam column attached to it, and a sample stage that is located in the sample chamber and supports a sample, comprising:
a step of changing a trajectory of the ion beam generated from the ion beam column by changing an angle between the ion beam and an extended line of a center axis of the ion beam column using a movable electrode unit that is placed in the sample chamber and is provided with an electric voltage, so that the ion beam is irradiated onto the sample supported by the sample stage.

15. The method of irradiating charged particle beam according to claim 14, further comprising:
a step of controlling a location of the electrode unit and an inclination angle of the electrode unit.

16. The method of irradiating charged particle beam according to claim 15, wherein:
the electrode unit movement controller locates the electrode unit below the sample supported by the sample stage viewed from the ion beam column so that the ion beam is irradiated onto the sample.

17. The method of irradiating charged particle beam according to claim 15, wherein:
an irradiation direction of the ion beam is changed using a first electrode unit placed near the ion beam column and a second electrode unit placed near the sample stage.

18. The method of irradiating charged particle beam according to claim 14, wherein:
a secondary ion or a secondary electron arriving at the electrode unit is detected by an electric current measuring unit, and a scanning ion microscope image is formed according to the secondary ion or the secondary electron measured by the electric current measuring unit.
